# EUROPEAN PATENT SPECIFICATION

(11) **EP 2 443 678 B1**
(45) Date of publication and mention of the grant of the patent: **27.03.2013**
(21) Application number: 10728416.8
(22) Date of filing: 18.06.2010
(51) Int. Cl.: H01L 41/18, H01L 41/22, H01L 41/08

(54) **METHOD FOR MANUFACTURING A MAINLY FILM SHAPED PIEZOELECTRIC ELEMENT**
VERFAHREN ZUR HERSTELLUNG EINES HAUPTSÄCHLICH FILMFÖRMIGEN PIEZOELEKTRISCHEN ELEMENTS
Procédé de fabrication d'élément piézoélectrique en forme de film principal

(30) Priority: 19.06.2009 EP 09163272
(43) Date of publication of application: 25.04.2012
(73) Proprietor: Nederlandse Organisatie voor toegepast- natuurwetenschappelijk onderzoek TNO, 2628 VK Delft (NL)
(72) Inventor: VAN DEN ENDE, Daan Anton, NL-3021 CJ Rotterdam (NL); GROEN, Wilhelm Albert, NL-5626 GB Eindhoven (NL)
(74) Representative: Jansen, Cornelis Marinus
(86) International application number: PCT/NL2010/050376
(87) International publication number: WO 2010/147470

(56) References cited:
- EP-A1- 0 061 374
- EP-A1- 1 578 015
- EP-A1- 1 940 021
- WO-A1-01/33648
- WO-A1-2005/088834
- ERIK SCHAFFER ET AL: "Electrically induced structure formation and pattern transfer" NATURE, vol. 403, 24 February 2000 (2000-02-24), pages 874-877, XP002174844
- TSIARTAS P C ET AL: "Photocurable pillar arrays formed via AC- and ultrasound-induced electrohydrodynamic instabilities" PROCEEDINGS OF THE SPIE - THE INTERNATIONAL SOCIETY FOR OPTICAL ENGINEERING SPIE-INT. SOC. OPT. ENG. USA, vol. 6151, no. 1, 61513G, 2 April 2006 (2006-04-02), pages 1-7, XP002595725 ISSN: 0277-786X

## Description

The present invention refers to a method for manufacturing a mainly film shaped piezoelectric element, comprising a first and a second set of electrodes which extend mainly coplanar and alternately one another, the electrodes being connected with a layer of piezoelectric material.

EP1983584 discloses such a piezoelectric element in which the piezoelectric material comprises a plurality of fibers in juxtaposition. Conductive patterns are provided which form a pattern of interdigitated electrodes.

US5852337 discloses a piezoelectric film-type element including a piezoelectric operating layer constructed by successively and integrally forming and stacking, on a ceramic substrate, a single flat film-shaped lower electrode, a piezoelectric layer, and an upper electrode comprising a plurality of alternately arranged strip electrodes.

Due to their application of a ceramic substrate and their structure consisting of several layers (i.e. one ceramic substrate and two electrode layers), the strain characteristics of the known piezoelectric elements are limited and they are not very fit for applications, in which the elements need to bend under rather rough conditions, e.g. for harvesting strain energy in car tyres. In both US5852337 and EP1983584 the piezoelectric phase extends in at least one dimension and damage to the device, i.e. cracking, may occur due to the lower strain tolerance of this layer if the layer is a piezoelectric ceramic. A loss in electrical properties will occur as a result of this damage. EP61374, DE476506, EP295895, GB2243946, US4407054 and WO2005/06985 disclose methods of manufacturing piezoelectric elements in which the orientation of piezoelectric particles occurs during manufacture.

Further methods and devices known in the prior art are described by Erik Schäffer et al., "Electrically induced structure formation and pattern transfer", Nature, vol. 403, p. 874-877, (2000); Pavlos C. Tsiartas, "Photocurable Pillar Arrays Formed via AC- and Ultrasound-Induced Electrohydrodynamic Instabilities", Proceedings of the SPIE - The International Society for Optical Engineering, vol. 6151, no. 1, 61513G, p. 1-7, (2006); EP 0 061 374 A1; EP 1 578 015 A1; WO 2005/088834 A1; WO 01/33648 A1; EP 1 940 021 A1.

One aim of the present invention is to provide a method for manufacturing a mainly film shaped piezoelectric element having advanced reliability properties under rough conditions, especially with respect to tolerance against large deformation strains in the direction of the piezoelectric ceramic phase.

Another aim of the present invention is to provide a thinner film shaped piezoelectric element.

Yet another aim of the present invention is to provide a film shaped piezoelectric element having improved yield of electric power.

According to a first aspect, the present invention may provide a method of manufacturing a mainly film shaped piezoelectric element as defined in appended claim 1.

The piezoelectric particles in the chains may be interconnected by short range attractive forces, which may include van der Waals and/or electrostatic forces. Although van der Waals and/or electrostatic forces provide the main contribution to the short range attractive forces maintaining the chain structure, additionally, before and during curing, interfacial and surface forces may also provide a contribution, and, during and after curing, chemical bonds may also provide a contribution via reactions of the particle surfaces with the reactive elements in the fluid. Such bonds are retained when the fluid is cured.

The first and second sets of electrodes are preferred to comprise interdigitated electrodes in one plane provided on a provisional or permanent support layer. If provisional, it is removed after the last processing step; if permanent, it is not removed.

The mixture of a fluid, uncured synthetic material and piezoelectric particles may be provided to the same provisional or permanent support layer. The piezoelectric particles may contain e.g. barium titanate (BaTiO₃), lead titanate (PbTiO₃), lead zirconate titanate (Pb[ZrₓTi₁₋ₓ]O₃ 0<x<1; known as PZT and the most common piezoelectric ceramic in use today, sodium potassium niobate ([Naₓ K₁₋ₓ]NbO₃), lithium niobate (LiNbO₃), lithium tantalate (LiTaO₃), sodium bismuth titanate (N_{0.5} Bi_{0.5}]TiO₃ sodium tungstate (Na₂WO₃), Ba₂NaNb₅O₅ and/or Pb₂KNbO₅. The aforementioned piezoelectric materials may be in their pure form or with added dopants, in the case of lead zirconate titanate this may be 0.1% to over 10% of elements such as La, Nb, Fe, Ni, Cu and Ba. In the case of sodium potassium niobate, this may be 0.1 to over 10% of elements such as Li or Ta. The particles may be spherical, ellipsoidal or polyhedral, such as are obtained by ball milling or various bottom up synthesis methods, such as the various types of nano-structured particles which may be fabricated from e.g. sol-gel precursors, such as platelets, whiskers or fibres.

It is provided, by any suitable method, that the layer of said mixture covers the electrodes of the first and second set of electrodes.

Preferably, after a chain building sequence, the chains are arranged to migrate intact towards a major face of the element. Depending on the viscosity of the uncured synthetic material, just removing (or decreasing) the electric field causes the particle chains -provided that the mixture layer and thus the chains are (mainly) horizontally oriented- to sink and to settle upon each other, resulting in an increase of the concentration of piezoelectric particles, while largely maintaining their chained structure. Optional application of a DC electric field mainly perpendicular to the plane of the electrodes may enhance this settling behaviour. Application of a DC electric field may be necessary in instances where the viscosity of the uncured synthetic material is relatively high. This electric field may for instance be generated by at least one substantially pointed voltage electrode while grounding the first and second set of electrodes. Alternatively, the bottom surface of the substrate layer may be provided with an electrode and a voltage may be applied to this electrode while grounding the first and second set of electrodes. In this case the applied electric field may also be an alternating electric field. In either case, application of this perpendicular electric field will cause densification of the particle chains towards the said major face of the element and cause a gradient in material properties across the thickness of the film i.e. perpendicular to the film plane.

The preceding steps may be repeated by applying again or by increasing the electric field over the first and second set of electrodes, and removing or decreasing it again, applying a perpendicular electric field etc., causing a continuation of the piezoelectric chain particle concentration in the region between the electrodes.

After the intended particle chain concentration has been reached, the mixture layer is cured in any suitable way, e.g. chemically or thermally induced or by irradiating the synthetic fluid with ultraviolet light or by a combination of the above. After curing the mixture layer -which has been converted into a layer which contains a multitude of piezoelectric particle chains between the electrodes- has become solid. Depending on the particularly used materials, it may be possible to remove the original support layer which was provided provisionally for forming the proper piezoelectric layer including the coplanar electrodes. Without the support layer the piezoelectric element will have minimum thickness.

As will be elucidated hereinafter, the support layer may be provided with cavities between the electrodes, in order to provide room to the particle chains to be formed between the electrodes and providing that the chains will take a plane-symmetrical position.

Preferably, a DC voltage is applied over the first and second set of electrodes after curing of the mixture causing poling of the piezoelectric particles between the electrodes.

According to a second aspect, the present invention may provide a mainly film shaped piezoelectric element comprising a first set of more than one electrode and a second set of more than one electrode that extend mainly coplanar and alternately one another, and a layer of piezoelectric material that is connected to the electrodes, said layer comprising a plurality of chains of interconnected piezoelectric particles extending between adjacent pairs of said electrodes.

Exemplary embodiments of the present invention are hereinafter described with reference to the accompanying drawings, in which:
- Figures 1a and 1b: show an exemplary embodiment of a piezoelectric element in view from above and in view from a side; and
- Figures 2a - 2f: show an illustration of the process according to the invention including one alternative embodiment.

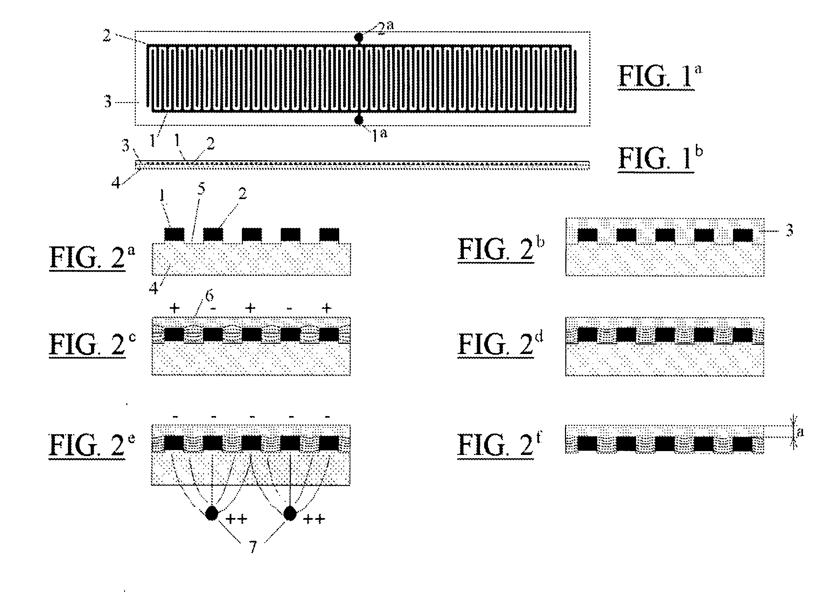

Figures 1a and 1b show a piezoelectric element which comprises a first and a second set (both more or less comb shaped) of electrodes 1 and 2 respectively which extend mainly coplanar and alternately one another, and which are connected with a layer of piezoelectric material 3. The complete structure may be supported by a substrate or support layer 4. The method for manufacturing the film shaped piezoelectric element shown in figures 1a and 1b, comprising the following steps has been illustrated in figures 2a - 2f.

Figure 2a illustrates providing the first and a second set of electrodes 1 and 2 on support layer 4, which can be performed using any well-known process like electro-etching in which electrode material is etched away from the support layer 4. Besides, the support layer material 4 may be etched away partly, resulting in cavities 5 between the electrodes.

Figure 2b shows providing a layer of a mixture of a fluid, uncured synthetic material and piezoelectric particles, which mixture covers the electrodes 1 and 2 and fills the rooms between them. The particles should be made from a material that has a higher dielectric permittivity than the fluid at the frequency used for forming the chains (see below). In this embodiment, the fluid is uncured epoxy and the particles are PZT particles with particle sizes ranging from 0.1µm to 10µm with average size of 1µm. The particles are mixed into the fluid at a concentration of 5-20vol% and the mixture is applied to the substrate over the comb shaped electrodes. It will be appreciated that the viscosity of the fluid is high enough, such that, upon mixing, the particles do not immediately sink to the bottom of the layer, but do so, at most, at a low rate that provides a sufficient window for chain formation as described below. The spacing between the electrodes is 1mm.

Next sequence, illustrated in figures 2c and 2d, may be repeated one or more times. Figure 2c illustrates applying an AC voltage of frequency of 1-10kHz (preferably 4kHz) between the first and second (set of) electrodes 1 and 2, thus providing electric fields 6 of about 200 V/mm to 2kV/mm in the mixture layer between those electrodes. As a result, the particles will rearrange into chains spanning the whole length of the spacing between the electrodes. When the particles have fully rearranged into chains the electric field for chain formation is removed. Fully rearranged means when a majority of the particles is either in direct contact with each other or close contact (i.e. gap between particles is <10 times the particle size, in the case of 1µm sized particles this would amount to <100nm). Figure 2d illustrates removing or decreasing the electric field applied to the first and second set of electrodes. Removing (or decreasing) the electric field will cause the particle chains 6 to sink (by gravitation) and to settle upon each other, resulting in an increase of the concentration of piezoelectric particles, while maintaining their chained structure. The particles will remain connected in chains because of the short range attractive forces (primarily van der Waals and electrostatic forces) even when the voltage is turned off. Those steps, illustrated in figures 2c and 2d are repeated by applying again or by increasing the electric field over the electrodes, and removing or decreasing that field again, etc., causing a continuation of the piezoelectric chain particle concentration process.

Optionally, this settling effect may be enhanced by application of a DC electric field in a direction substantially perpendicular to the plane of the first and second set of electrodes, which electric field will exert an attractive force to the particle chains in a direction perpendicular to the chains. While leaving the chain structure intact, the attraction of the chains towards the substrate leads to a densification of the piezoelectric phase in the uncured fluid medium and so in a gradient in piezoelectric properties in the area between the first and second set of electrodes. The electric field is of sufficient strength to impart movement of the particle chains, but is not so strong that it causes breaking of the particle chains. This process is illustrated in figure 2e. The electric field may for instance be generated within the uncured fluid by applying a point voltage of 1kV at 10mm under the substrate by a pointed voltage electrode 7 while grounding the first and second set of electrodes throughout the duration that the electric field is applied. This configuration has the advantage that the perpendicular electric field may be applied to the device without having to include an extra electrode layer to the system. In this configuration, the electric field which is generated by this point voltage source will cause an electrostatic force which, acting in cooperation with gravity, attracts the particle chains towards the substrate. The chains of particles will be pulled towards the bottom of the substrate, while the chains themselves remain intact and this will cause an increase in concentration of piezoelectric particles in the vicinity of the substrate (only in the region between the alternating electrodes) and therefore a gradient in piezoelectric particles and piezoelectricity of the composite material in the thickness direction.

Finally, the mixture layer 3 is cured. This may be done by increasing its temperature for a suitable period of time. The mixture layer 3 may also be cured by the application of ultraviolet light. During curing (by whatever method) it is preferred to re-apply the above-mentioned AC electric field to help to ensure that the chains maintain integrity during curing.

The result of all this is a high concentration of piezoelectric particle chains between the electrodes, causing that -after the mixture layer 3 has been cured and the chain particles have been poled-, in practical operation, the piezoelectric effect is very effective, especially when experiencing compressive stress in the lateral direction, causing a large yield of electric output at the terminals I a and 2a from which the "harvested" electric power can be collected when the piezoelectric element is subjected to mechanical deformations. Even though there is a high concentration of particle chains which have been formed between the electrodes, the mechanical properties of the piezoelectric element are still excellent compared with prior art film shaped piezoelectric elements, because the particles are held together by the relatively flexible matrix phase, which will take up most of the strain when the composite film is loaded in tension. This especially leads to greater resistance to cracking under tensile loading and thus fatigue tolerance.

Figure 2f illustrates that it may be preferred that the support layer 4 is removed -by any suitable means, e.g. by etching- after the mixture layer 3 has been cured. It is noted that the thickness *a* between the upper plane of the coplanar electrodes I and 2 and the upper plane of the completed piezoelectric element is of influence to the sensitivity of the element due to the fact that *a* determines the bending moment of the element, causing elongation and compression of the piezoelectric longitudinal chains formed between the coplanar electrodes 1 and 2.

An electric field, generated by a DC voltage over the electrodes is applied to the first and second set of electrodes after curing of the mixture, thus causing poling of the piezoelectric particles between the electrodes, which is necessary for the particles to act, together with the other particles in the piezoelectric chains between the electrodes, for piezoelectric electricity generation.

## Claims

1. A method of manufacturing a mainly film shaped piezoelectric element comprising a first set of more than one electrode and a second set of more than one electrode (1, 2) that extend mainly coplanar and alternately one another, and a layer of piezoelectric material that is connected to the electrodes, comprising:
providing said first and second sets of electrodes;
providing a mixture of a fluid, uncured synthetic material and piezoelectric particles;
providing a layer (3) of said mixture that connects the electrodes of said first and second set of electrodes;
performing a chain building sequence one or more times, the chain building sequence comprising:
· applying or increasing an AC voltage to the first and second set of electrodes so as to provide electric fields in said mixture layer between the alternating electrodes of the first and second set of electrodes respectively that cause the piezoelectric particles to spatially arrange as chains of interconnected particles between those electrodes;
· removing or decreasing said AC voltage applied to the first and second set of electrodes;
the method further comprising curing the mixture layer.

2. A method according to claim 1, wherein the piezoelectric particles in the chains are interconnected by a short range attractive force that includes van der Waals forces and/or electrostatic forces.

3. A method according to any preceding claim, wherein the chains span all or most of the length of the spacing between an adjacent pair of said electrodes.

4. A method according to any preceding claim, wherein, after a said chain building sequence, the chains are arranged to migrate intact towards a major face of the element.

5. A method according to any preceding claim, wherein said migration takes place under the influence of an electric field applied in a direction substantially perpendicular to the plane of the first and second set of electrodes.

6. A method according to any of claims 4 or 5, wherein said migration takes place under the influence of gravity.

7. A method according to any preceding claim, wherein the first and second set of electrodes and the mixture of a fluid, uncured synthetic material and piezoelectric particles are applied on a support layer (4).

8. A method according to claim 7, wherein the support layer is provided with cavities (5) between the electrodes.

9. A method according to claim 7, wherein the support layer is maintained after the mixture layer has been cured.

10. A method according to claim 7, wherein the support layer is removed after the mixture layer has been cured.

11. A method according to any preceding claim, wherein an AC voltage is applied to the first and second set of electrodes during curing.

12. A method according to any preceding claim, wherein a DC voltage is applied over the first and second set of electrodes after curing of the mixture causing poling of the piezoelectric particles between the electrodes.

13. A mainly film shaped piezoelectric element comprising a first set of more than one electrode and a second set of more than one electrode that extend mainly coplanar and alternately one another, and a layer of piezoelectric material that is connected to the electrodes, **characterized by** said layer comprising a plurality of chains of interconnected piezoelectric particles extending between adjacent pairs of said electrodes.

14. A piezoelectric element according to claim 13, wherein the density of chains within said layer decreases from one major face of the element to the opposite major face of the element.

## Patentansprüche

1. Verfahren zum Herstellen eines hauptsächlich filmförmigen piezoelektrischen Elements, umfassend einen ersten Satz aus mehr als einer Elektrode und einen zweiten Satz aus mehr als einer Elektrode (1, 2), die sich hauptsächlich koplanar und einander abwechselnd erstrecken, und eine Schicht aus piezoelektrischem Material, das mit den Elektroden verbunden ist, umfassend:
Vorsehen des ersten und eines zweiten Satzes von Elektroden;
Vorsehen einer Mischung aus einem fluiden, nicht gehärteten synthetischen Material und piezoelektrischen Teilchen;
Vorsehen einer Schicht (3) der Mischung, die die Elektroden des ersten und des zweiten Satzes von Elektroden verbindet;
ein- oder mehrmaliges Durchführen einer Kettenbildungssequenz, wobei die Kettenbildungssequenz umfasst:
Anlegen oder Erhöhen einer Wechselspannung an den ersten und den zweiten Satz von Elektroden, um so elektrische Felder in der Mischungsschicht zwischen den abwechselnd angeordneten Elektroden des ersten bzw. des zweiten Satzes von Elektroden vorzusehen, was dazu führt, dass die piezoelektrischen Teilchen sich räumlich als Ketten von miteinander verbundener Teilchen zwischen diesen Elektroden anordnen;
Abschalten oder Verringern der an den ersten und den zweiten Satz von Elektroden angelegten Wechselspannung;
wobei das Verfahren ferner Härten der Mischungsschicht umfasst.

2. Verfahren gemäß Anspruch 1, wobei die piezoelektrischen Teilchen in den Ketten durch eine Anziehungskraft von geringer Reichweite miteinander verbunden sind, die Van-der-Waals-Kräfte und/oder elektrostatische Kräfte beinhaltet.

3. Verfahren gemäß einem der vorhergehenden Ansprüche, wobei sich die Ketten über die gesamte Länge oder einen Großteil der Länge des Abstands zwischen einem benachbarten Paar Elektroden erstrecken.

4. Verfahren gemäß einem der vorhergehenden Ansprüche, wobei nach einer genannten Kettenbildungssequenz die Ketten so angeordnet sind, dass sie intakt zu einer Hauptfläche des Elements hin wandern.

5. Verfahren gemäß einem der vorhergehenden Ansprüche, wobei die Wanderung unter dem Einfluss eines elektrischen Felds erfolgt, das in einer Richtung im Wesentlichen senkrecht zu der Ebene des ersten und des zweiten Satzes von Elektroden angelegt ist.

6. Verfahren gemäß einem der Ansprüche 4 oder 5, wobei die Wanderung unter dem Einfluss von Schwerkraft erfolgt.

7. Verfahren gemäß einem der vorhergehenden Ansprüche, wobei der erste und der zweite Satz von Elektroden und die Mischung eines fluiden, nicht gehärteten synthetischen Materials und piezoelektrischer Teilchen auf einer Trägerschicht (4) aufgebracht werden.

8. Verfahren gemäß Anspruch 7, wobei die Trägerschicht mit Hohlräumen (5) zwischen den Elektroden ausgestattet ist.

9. Verfahren gemäß Anspruch 7, wobei die Trägerschicht behalten wird, nachdem die Mischungsschicht gehärtet wurde.

10. Verfahren gemäß Anspruch 7, wobei die Trägerschicht entfernt wird, nachdem die Mischungsschicht gehärtet wurde.

11. Verfahren gemäß einem der vorhergehenden Ansprüche, wobei während des Härtens eine Wechselspannung an den ersten und den zweiten Satz von Elektroden angelegt wird.

12. Verfahren gemäß einem der vorhergehenden Ansprüche, wobei über den ersten und den zweiten Satz von Elektroden eine Gleichspannung angelegt wird, nachdem die Mischung gehärtet wurde, wodurch eine Polung der piezoelektrischen Teilchen zwischen den Elektroden bewirkt wird.

13. Hauptsächlich filmförmiges piezoelektrisches Element, umfassend einen ersten Satz aus mehr als einer Elektrode und einen zweiten Satz aus mehr als einer Elektrode, die sich hauptsächlich koplanar und einander abwechselnd erstrecken, und eine Schicht aus piezoelektrischem Material, die mit den Elektroden verbunden ist, **dadurch gekennzeichnet, dass** die Schicht eine Mehrzahl von Ketten miteinander verbundener piezoelektrischer Teilchen umfasst, die sich zwischen benachbarten Paaren der Elektroden erstrecken.

14. Piezoelektrisches Element gemäß Anspruch 13, wobei die Dichte der Ketten innerhalb der Schicht von einer Hauptfläche des Elements zur entgegengesetzten Hauptfläche des Elements geringer wird.

## Revendications

1. Procédé de fabrication d'un élément piézo-électrique principalement sous forme de film, comprenant un premier ensemble constitué de plus d'une électrode et un deuxième ensemble constitué de plus d'une électrode (1, 2) qui ont une extension principalement coplanaire et qui alternent l'un avec l'autre, et une couche de matériau piézo-électrique qui est reliée aux électrodes, ledit procédé comprenant les étapes consistant à :
préparer lesdits premier et deuxième ensembles d'électrodes;
préparer un mélange d'un matériau synthétique non polymérisé fluide et de particules piézo-électriques ;
préparer une couche (3) dudit mélange qui relie les électrodes dudit premier et dudit deuxième ensemble d'électrodes ;
exécuter une séquence de formation de chaînes à une ou plusieurs reprises, la séquence de formation de chaînes comprenant :
- l'application ou l'augmentation d'une tension alternative au premier et au deuxième ensemble d'électrodes afin de générer des champs électriques dans ladite couche de mélange entre les électrodes alternées du premier et du deuxième ensemble d'électrodes, respectivement, de façon à forcer les particules piézo-électriques à s'ordonner spatialement entre ces électrodes sous la forme de chaînes de particules reliées entre elles ;
- la suppression ou la diminution de ladite tension alternative appliquée au premier et au deuxième ensemble d'électrodes ;
le procédé comprenant en outre la polymérisation de la couche de mélange.

2. Procédé selon la revendication 1, dans lequel les particules piézo-électriques présentes dans les chaînes sont reliées entre elles par une force d'attraction à courte distance qui comprend des forces de van der Waals et/ou des forces électrostatiques.

3. Procédé selon l'une quelconque des revendications précédentes, dans lequel les chaînes occupent la totalité ou la majeure partie de la longueur de l'écartement entre une paire adjacente desdites électrodes.

4. Procédé selon l'une quelconque des revendications précédentes, dans lequel, après une dite séquence de formation de chaînes, les chaînes sont agencées de façon à migrer intactes en direction d'une face principale de l'élément.

5. Procédé selon l'une quelconque des revendications précédentes, dans lequel ladite migration a lieu sous l'effet d'un champ électrique appliqué dans une direction sensiblement perpendiculaire au plan du premier et du deuxième ensemble d'électrodes.

6. Procédé selon l'une quelconque des revendications 4 ou 5, dans lequel ladite migration a lieu sous l'effet de la pesanteur.

7. Procédé selon l'une quelconque des revendications précédentes, dans lequel le premier et le deuxième ensemble d'électrodes et le mélange de matériau synthétique non polymérisé fluide et de particules piézo-électriques sont appliqués sur une couche support (4).

8. Procédé selon la revendication 7, dans lequel la couche support est dotée de cavités (5) entre les électrodes.

9. Procédé selon la revendication 7, dans lequel la couche support est maintenue après la polymérisation de la couche de mélange.

10. Procédé selon la revendication 7, dans lequel la couche support est enlevée après la polymérisation de la couche de mélange.

11. Procédé selon l'une quelconque des revendications précédentes, dans lequel une tension alternative est appliquée au premier et au deuxième ensemble d'électrodes lors de la polymérisation.

12. Procédé selon l'une quelconque des revendications précédentes, dans lequel une tension continue est appliquée au premier et au deuxième ensemble d'électrodes après la polymérisation du mélange afin de provoquer la polarisation des particules piézo-électriques entre les électrodes.

13. Élément piézo-électrique, principalement sous forme de film, comprenant un premier ensemble de plus d'une électrode et un deuxième ensemble de plus d'une électrode qui ont une extension principalement coplanaire et qui alternent l'un avec l'autre, et une couche de matériau piézo-électrique qui est reliée aux électrodes, **caractérisé en ce que** ladite couche comprend une pluralité de chaînes de particules piézo-électriques reliées entre elles qui s'étendent entre des paires adjacentes desdites électrodes.

14. Élément piézo-électrique selon la revendication 13, dans lequel la densité de chaînes à l'intérieur de ladite couche diminue depuis une face principale de l'élément jusqu'à la face principale opposée de l'élément.
